# EUROPÄISCHE PATENTANMELDUNG

(11) **EP 2 466 998 A1**
(43) Veröffentlichungstag der Anmeldung: **20.06.2012**
(21) Anmeldenummer: 11188768.3
(22) Anmeldetag: 11.11.2011
(51) Int. Cl.: H05K 1/02

(54) **Leiterplatte mit Schirmung**

(30) Priorität: 16.12.2010 DE 102010063245
(71) Anmelder: SEMIKRON Elektronik GmbH & Co. KG, 90431 Nürnberg (DE)
(72) Erfinder: Mitzel, Mario, 90409 Nürnberg (DE); Weigel, Alexander, 91452 Wilhermsdorf (DE)

(57) **Zusammenfassung**

Eine Leiterplatte (2), mit einer eine Oberseite (6) und eine Unterseite (8) aufweisenden, sich flächig erstreckenden Trägerplatte (4), mit mindestens einer ersten Leiterbahnebene (10a) und einer zweiten, zur ersten beabstandeten Leiterbahnebene (10b), mit einer zumindest einen Teilbereich (18) der Trägerplatte (4) einnehmenden elektrischen Schaltung (12), enthält eine die Schaltung (12) gegen elektromagnetische Störstrahlung abschirmende Schirmung (20),
- wobei die Schirmung (20) eine auf der ersten Leiterbahnebene (10a) angeordnete, den Teilbereich (18) geschlossen umgrenzende, erste Schirmungsleiterbahn (22a),
- und eine auf der zweiten Leiterbahnebene (10b) angeordnete, den Teilbereich (18) geschlossen umgrenzende, zweite Schirmungsleiterbahn (22b) enthält,
- wobei erste (22a) und zweite Schirmungsleiterbahn (22b) zumindest in einem die Schaltung (12) geschlossen umgrenzenden Umfangsbereich (24) deckungsgleich sind,
- und die Schirmung (20) im Umfangsbereich (24) mehrere, die Trägerplatte (4) durchsetzende, die erste (22a) und die zweite Schirmungsleiterbahn (22b) verbindende Durchkontaktierungen (26) enthält.

## Beschreibung

Die Erfindung betrifft eine Leiterplatte mit einer Schirmung.

Eine in Rede stehende Leiterplatte - auch Platine genannt - dient zum Aufbau elektrischer Schaltungen und weist eine Trägerplatte mit einer Ober- und Unterseite auf. Eine Trägerplatte weist in der Regel die Form eines sich flächig erstreckenden, sehr dünnen Quaders auf, dessen Flachseiten dann Ober-und Unterseite bilden. Beispielsweise ist die Unter- und/oder Oberseite mit Bauelementen bestückt. Bei klassischen Bauelementen durchdringen deren Anschlüsse bzw. Anschlussdrähte die Trägerplatte. SMD-Bauelemente (surface mounted device) hingegen sind lediglich direkt an der Oberfläche, also der Ober-oder Unterseite angeordnet. Auf der Unter- und Oberseite sind elektrische Leiterbahnen angebracht, die die Anschlüsse der Bauelemente verbinden. Weitere elektrische Verbindungen zwischen Ober- und Unterseite entstehen mit Hilfe von Durchkontaktierungen zwischen zwei übereinanderliegenden Abschnitten von Leiterbahnen. Es sind auch mehrlagige Leiterplatten bekannt, bei welchen auch im Inneren der Trägerplatte eine oder mehrere Leiterbahnebenen angeordnet sind. Sämtliche Leiterbahnebenen sowie Ober- und Unterseite liegen in der Regel parallel zueinander.

Durch Schaltereignisse der auf der Leiterplatte befindlichen Schaltungen wird innerhalb der Leiterplatte elektromagnetische Störstrahlung erzeugt. Hier spricht man auch von EMV-Ereignissen (Elektromagnetische Verträglichkeit). Die Störstrahlung wird an die Umwelt abgegeben, mit anderen Worten entsteht eine auskoppelnde Störstrahlung. Auf umgekehrtem Weg kann auch außerhalb der Leiterplatte auftretende Störstrahlung auf den Schaltungen der Leiterplatte unerwünschte EMV-Effekte auslösen und die Funktion der Schaltungen nachhaltig stören. Die elektrische Schaltung ist deshalb gegenüber der Umgebung mit Hilfe einer gegen elektromagnetische Störstrahlung wirkenden Abschirmvorrichtung, kurz (EMV-)Schirmung genannt, abzuschirmen. Ohne eine solche EMV-Schirmung kann leicht von außen Störstrahlung in die Leiterplatte bzw. Schaltung einkoppeln und empfindliche Signalleitungen, d.h. die elektrischen Signale auf den Leiterbahnen stören. Zudem können durch Störabstrahlung andere Geräte gestört werden.

Die Schirmung muss nicht komplett um die gesamte Leiterplatte bzw. deren gesamte Beschaltung angeordnet werden, sondern kann auch nur zwischen bezüglich EMV störungsempfindlichen Teilschaltungen, also Teilen einer Gesamtschaltung angeordnet werden, um eine Verbesserung des EMV-Verhaltens der gesamten Leiterplatte zu erzielen. Dies ist z.B. bei einer Ansteuerschaltung für einen Leistungshalbleiterschalter, wie einen IGBT (insulated gate bipolar transistor) oder MOSFET (metal oxide semiconductor field effect transistor) wichtig, um eine sichere Trennung einer Primärseite, welche Kleinspannungen aufweist, gegen eine Sekundärseite - mit teilweise sehr hohen Spannungen - zu erreichen. Spannungen können hierbei bis zu 1700V betragen. Primärseite und Sekundärseite entsprechen dann einzelnen Teilschaltungen auf einer gemeinsamen Platine, welche jeweils für sich mit einer Schirmung zu versehen sind.

Hierzu sind verschiedene Abschirmvorrichtungen bzw. Schirmungen bekannt. Beispielsweise ist eine Ausführungsform bekannt, bei der als Schirmung die umlaufende Kante der Leiterplatte, also der jeweils Ober- und Unterseite gemeinsam begrenzende Rand der Leiterplatte, metallisiert wird. Hierdurch wird eine Verbesserung des EMV-Verhaltens der Leiterplatte und eine gleichzeitige zusätzliche Wärmeabfuhrmöglichkeit bzw. eine zusätzliche Masse (GND, Ground) an der Leiterplattenkante geschaffen.

Bei der bekannten Ausführungsform kann sich die auf bzw. über den Rand der Leiterplatte aufgebrachte Metallisierung bei der Handhabung der Leiterplatte leicht von der Trägerplatte lösen. Zudem werden hier fertigungstechnisch die Ecken der Leiterplatte, wo also zwei Kanten aufeinanderstoßen, nicht metallisiert. Hier entsteht eine Lücke in der EMV-Schirmung.

Aufgabe der Erfindung ist es, eine verbesserte Leiterplatte mit Schirmung anzugeben.

Die Aufgabe wird gelöst durch eine Leiterplatte gemäß Patentanspruch 1 mit einer Trägerplatte, welche eine Ober- und eine Unterseite aufweist. Die Leiterplatte enthält eine elektrische Schaltung, d.h. in der Regel Bauelemente und Leiterbahnen, welche zumindest einen Teilbereich der Trägerplatte einnimmt. Der Teilbereich umfasst hierbei eine deckungsgleiche Teilfläche der Ober- und Unterseite und das dazwischen liegende Volumen der Trägerplatte. Mit anderen Worten sind also zumindest auf einer Teilfläche der Leiterplatte Bauteile und Leiterbahnen der Schaltung vorhanden. Die Leiterplatte enthält außerdem mindestens eine erste und eine zweite Leiterbahnebene, die zur ersten beabstandet ist. Die Leiterbahnebenen können sich auf der Ober- und/oder Unterseite, aber auch im Inneren der Leiterplatte befinden. Weitere Leiterbahnebenen können vorhanden sein. Auf den Leiterbahnebenen sind die Leiterbahnen der Schaltung angeordnet. U.U. sind noch Durchkontaktierungen vorgesehen, die die Leiterbahnen bzw. Bauteile auf verschiedenen Leiterbahnebenen verbinden.

Die Leiterplatte weist außerdem eine erfindungsgemäße Schirmung auf, welche die Schaltung gegen elektromagnetische Strahlung abschirmt. Die Schirmung enthält eine erste Schirmungsleiterbahn, welche auf der ersten Leiterbahnebene angeordnet ist und den Teilbereich der Trägerplatte, welchen die Schaltung einnimmt, geschlossen umgrenzt. Die Schirmung enthält weiterhin eine auf der zweiten Leiterbahnebene angeordnete, ebenfalls den Teilbereich geschlossen umgrenzende zweite Schirmungsleiterbahn. Zumindest auf einem Umfangsbereich, welcher ebenfalls die Schaltung bzw. den Teilbereich geschlossen umgrenzt, sind erste und zweite Schirmungsleiterbahn bezüglich der Leiterplatte deckungsgleich, also senkrecht zu deren Ober- bzw. Unterseite zueinander versetzt.

Mit anderen Worten liegen auf ersten und zweiten Leiterbahnebene im Umfangsbereich zumindest Teile der ersten und zweiten Schirmungsleiterbahn deckungsgleich übereinander. Die Schirmung weist weiterhin mehrere, jeweils das Substrat - i.d.R. senkrecht zur Ober-/Unterseite - durchdringende Durchkontaktierungen auf, welche jeweils die erste und zweite Schirmungsleiterbahn elektrisch leitend verbinden. Sämtliche Durchkontaktierungen liegen im Umfangsbereich und umringen ebenfalls in ihrer Gesamtheit den Teilbereich.

In Abständen von z.B. typischerweise 0,5-5mm werden also entlang der gesamten Schirmung, d.h. entlang der gesamten oberen und unteren Schirmungsleiterbahn im Umfangsbereich durchkontaktierte Vias, also Durchkontaktierungen platziert, um obere und untere, also erste und zweite Schirmungsleiterbahn elektrisch zu verbinden. Die Durchkontaktierungen verlaufen i.d.R. senkrecht zur Ober- und Unterseite und haben mindestens eine Höhe, die von der ersten zur zweiten Leiterbahnebene reicht, in der Regel durchdringen sie jedoch die gesamte Höhe bzw. Dicke der Leiterplatte.

Erste und zweite Schirmungsleiterbahn bilden also zusammen mit den Durchkontaktierungen eine Art Ring um die Schaltung bzw. den Teilbereich, welcher eine Schirmung, also eine Abschirmvorrichtung der Schaltung gegen elektromagnetische Strahlung, darstellt. Erste und zweite Schirmungsleiterbahn umringen den Teilbereich also auf verschiedenen Höhen- bzw. Dickenpositionen der Leiterplatte. Die erste und zweite Schirmungsleiterbahn und die Durchkontaktierungen sind elektrisch leitende Strukturen, z.B. aus Kupfer, Aluminium oder sonstigen elektrisch leitfähigen Materialien.

Bei der erfindungsgemäßen Leiterplatte wird durch die beschriebene Schirmung, welche die gesamte Schaltung im Bereich der Leiterplatte umgrenzt, gerade dort Störstrahlung reduziert und im besten Fall gänzlich abgeblockt. Durch die erfindungsgemäße Schirmung wird eine verbesserte Abschwächung bzw. eine Beseitigung einkoppelnder oder auskoppelnder Störstrahlung erreicht.

Mit anderen Worten bildet die Schirmung ein die Leiterplatte von der ersten zur zweiten Leiterbahnebene nahezu senkrecht durchdringendes Gitter, welches die Schaltung und insbesondere deren Leiterbahnen vollständig umgrenzt. Da eine Einkopplung und Abstrahlung von Störstrahlung in der Regel hauptsächlich im Bereich der Leiterplatte und dort am die Schaltung umgrenzenden bzw. den Teilbereich umgrenzenden Rand stattfindet, wird diese besonders wirksam unterbunden.

In einer einfachen Ausführungsform ist die erste Leiterbahnebene an der Oberseite und die zweite Leiterbahnebene an der Unterseite der Leiterplatte angeordnet. Die Schirmung erstreckt sich dann über die gesamte Höhe bzw. Dicke der Trägerplatte von der Ober- zur Unterseite.

Wie oben erwähnt, kann eine Leiterplatte mindestens eine weitere, zwischen Ober- und Unterseite angeordnete Leiterbahnebene aufweisen. Hierbei handelt es sich also um eine sogenannte mehrlagige oder Multilayer-Leiterplatte, welche nicht nur beispielsweise auf der Ober- und Unterseite freiliegende Leiterbahnen, sondern auch im Inneren mehrere Leiterbahnebenen aufweisen. Bekannt sind hier Leiterplatten mit bis zu zwanzig inneren Leiterbahnebenen oder Leiterlagen.

Zwei Schirmungsleiterbahnen können hier weiterhin auf der Ober- und Unterseite oder auf beabstandeten Zwischenlagen angeordnet sein. Die zwischen den beiden, die Schirmungsleiterbahnen tragenden Ebenen liegenden Leiterbahnebenen müssen dann nicht unbedingt eigene, dritte oder weitere Schirmungsleiterbahnen aufweisen. Die Abstände der ersten und zweiten Schirmungsleiterbahn sind hier in der Regel klein genug, um den gewünschten Abschirmeffekt gegen Störstrahlung auch für dazwischenliegende Leiterbahnebenen zu erzeugen.

In einer vorteilhaften Ausführungsform befindet sich jedoch auch in der mindestens einen weiteren Leiterbahnebene eine weitere Schirmungsleiterbahn, die insofern der ersten und zweiten Schirmungsleiterbahn entspricht, dass sie auch den Umfangsbereich bedeckt. Auch jede weitere Schirmungsleiterbahn ist dann ebenfalls mit den Durchkontaktierungen verbunden. So wird die Schirmung mit anderen Worten auch auf die Zwischenlagen einer Multilayer-Platine ausgedehnt. Mit anderen Worten können also bei mehrlagigen Leiterplatten auch im Inneren umlaufende Schirmungsleiterbahnen entsprechend der ersten und zweiten Schirmungsleiterbahn angebracht werden, welche dann ebenfalls mit Hilfe der Durchkontaktierungen in die Schirmung elektrisch eingebunden werden.

Eine Leiterbahnebene kann auch ausschließlich eine der Schirmung zugehörige Schirmungsleiterbahn, also eine Schirmungsleitung, enthalten. Die signalführenden Leiterbahnen der Schaltung sind dann in anderen Leiterbahnebenen angeordnet.

Bei der vorteilhaften Ausführungsform ist mindestens eine der genannten Leiterbahnebenen eine zumindest den Teilbereich ganzflächig ausfüllende Masselage. Ganzflächig bedeutet hier, dass z.B. lediglich Durchtrittsbereiche, z.B. für Vias oder Anschlussleitungen von Bauelementen, aus der gesamten Fläche ausgespart sind, damit derartige Leitungen ohne Kontakt mit der Masselage diese senkrecht durchtreten können. Mit anderen Worten entartet die ringförmige Schirmungsleiterbahn dieser Ebene zu einer ganzflächigen Masselage.

In der Regel wird eine entsprechende Leiterplatte dann mehrere Lagen aufweisen, wobei beispielsweise jeweils die der Ober-und Unterseite am nächsten liegende Leiterbahnebene als ganzflächige Masselage im obigen Sinne ausgeführt ist. Zwischen zwei Masselagen sind dann weitere Leiterbahnebenen angebracht. Durch die ober- und unterhalb dieser signalführenden Lagen liegenden Masselagen sind erstere dann gegenüber der Umgebung vollständig abgeschirmt. Die Masselagen, die mit der Schirmung verbunden sind, ergänzen diese also zu einem die Zwischenlagen vollständig kapselnden Käfig. Als Durchtrittspunkte aus dem Käfig ergeben sich lediglich die oben genannten Durchtrittsbereiche.

Derartige Platinen oder Leiterplatten besitzen also einen mehrlagigen Aufbau, u.U. mit mehreren Masselagen, welche u.U. auf Massepotenzial (GND) geführt sind. In der Regel sind sämtlichen Masselagen durch die Schirmung bzw. die Durchkontaktierungen miteinander verbunden. Hierdurch wird ein Masseverzug einzelner Masselagen gegeneinander verhindert und die Abschirmung von Störstrahlung weiter verbessert.

Mit anderen Worten entsteht so z.B. aus zwei voneinander beabstandeten Masselagen und die diese verbindenden, käfigartig verteilen Durchkontaktierungen eine Schirmung bzw. Abschirmvorrichtung, welche tatsächlich die gesamte, zwischen den Masselagen und innerhalb der Schirmung liegende Schaltung gegen Störstrahlung sicher abschirmt und so Störungen aufgrund von EMV-Effekten vermieden sind.

So kann dann insbesondere die erste und zweite Schirmungsleiterbahn jeweils zu einer Masselage entarten, die sich z.B. jeweils im Inneren der Trägerplatte befinden. Zusammen mit den Durchkontaktierungen ergibt sich dann der o.g. vollständige Abschirm- bzw. Käfigeffekt.

In einer bevorzugten Ausführungsform ist die Schirmung eine im Randbereich der Leiterplatte angeordnete, die Leiterplatte vollständig umlaufende Schirmung. So werden sämtliche auf der Leiterplatte vorhandenen Schaltungsteile oder Teilschaltungen vollständig umschlossen. Eine Platzierung der Schirmung am Rand der Schaltung bzw. Leiterplatte kann außerdem als zusätzlicher ESD-Schutz (Electrostatic Discharge) vor Berührungen wirksam sein. Beispielsweise sind erste und zweite Schirmungsleiterbahn auf der Ober- und Unterseite der Platine zu finden und elektrisch nicht isoliert. Bei Berührung der Baugruppe z.B. mit den Fingern eines Benutzers geraten sie dann in leitenden Kontakt mit dem Benutzer. So wird ein Potentialausgleich zwischen Benutzer und Leiterplatte bzw. deren Massepotential hergestellt, was zu einer sicheren Handhabung führt.

Die erste und zweite Schirmungsleiterbahn könnte dann allerdings, wenn diese auf der Ober- und Unterseite angeordnet sind, bei der Handhabung der Platine leicht beschädigt werden. Um dies zu verhindern, kann dann die erste und zweite Schirmungsleiterbahn nicht ganz bis zum Rand der Leiterplatte geführt sein, sondern noch von einem kleinen Abstandsbereich umschlossen sein. Beispielsweise wird also auf der Ober- und Unterseite der Leiterplatte ein etwa 1mm breiter Abstandsbereich am Rand freigelassen, d.h. erste und zweite Schirmungsleiterbahn werden jeweils mit Abstand von 1mm zum Rand als z.B. ebenfalls 1mm breite Schirmungsleiterbahnen platziert. Randabstände und Breiten der Schirmungsleiterbahnen können hierbei jedoch variieren.

In einer bevorzugten Ausführungsform der Erfindung ist die Schirmung mit einem Massepotenzial verbunden. Die gesamte Schirmung ist dann z.B. geerdet, wenn diese mit einem Massepotenzial GND (Ground) verbunden ist. Alternativ könnte jedoch auch die Schirmung eben nicht mit einem Massepotenzial verbunden, sondern vollständig elektrisch isoliert sein, hier spricht man von einer schwebenden oder floatenden Schirmung, deren Potenzial also in keiner Weise gegenüber einem anderen Potenzial elektrisch fixiert ist.

In einer weiteren Ausführungsform der Erfindung existieren auf der Leiterplatte mehrere, jeweils einen Teilbereich der Trägerplatte einnehmende elektrische Schaltungen. Hierbei kann nun auch jede der Schaltungen eine diese jeweils geschlossen umgrenzende eigene Schirmung aufweisen. So können sich auch innerhalb einer Leiterplatte gegeneinander abgeschirmte Schaltungen auf Teilbereichen der Trägerplatte nicht gegenseitig durch Störstahlung stören.

Bei einer weiteren bevorzugten Ausführungsform der Erfindung beträgt der Abstand zweier benachbarter Durchkontaktierungen zumindest annähernd dem Abstand zweier benachbarter Leiterbahnebenen. Insbesondere kann hier der kleinste auf der Leiterplatte auftretende Abstand zwischen zwei Leiterbahnebenen gewählt werden.

Für eine weitere Beschreibung der Erfindung wird auf die Ausführungsbeispiele der Zeichnungen verwiesen. Es zeigen, jeweils in einer schematischen Prinzipskizze:
Fig.1 eine Leiterplatte mit erfindungsgemäßer Schirmung,
Fig.2 die Leiterplatte aus Fig. 1 in Draufsicht,
Fig.3 eine alternative Leiterplatte im Detail,
Fig.4 eine alternative Leiterplatte in Draufsicht,
Fig.5 einen Schnitt durch eine Schirmung,
Fig.6 eine alternative Leiterplatte mit mehreren Leiterbahnebenen.

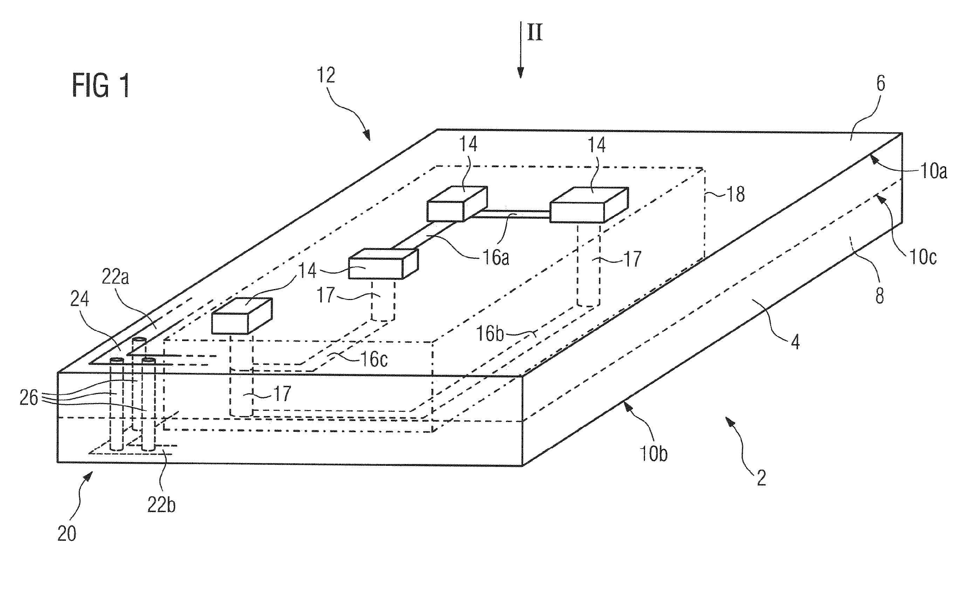

Fig. 1 zeigt eine Leiterplatte 2, welche eine Trägerplatte 4 enthält, die eine Oberseite 6 und eine Unterseite 8 aufweist. Die Trägerplatte 4 erstreckt sich flächig, also nach Art eines flachen Quaders zwischen Ober- und Unterseite 6,8, die die Flachseiten des Quaders bilden. Die Trägerplatte 4 enthält eine auf der Oberseite 6 angeordnete erste Leiterplattenebene 10a, eine zweite, an der Unterseite 8 angeordnete Leiterbahnebene 10b und eine zwischen beiden, d.h. im Inneren der Trägerplatte 4 verlaufende weitere Leiterbahnebene 10c, die in Fig. 1 gestrichelt angedeutet ist. Sämtliche Leiterbahnebenen 10a-c sind zueinander jeweils in Normalenrichtung der Leiterplatte 2, d.h. in Richtung von der Unterseite 8 zur Oberseite 6 hin, beabstandet.

Die Leiterplatte 2 enthält außerdem eine elektrische Schaltung 12, umfassend auf der Oberseite 6 angeordnete Bauelemente 14 sowie Leiterbahnen 16a-c. Die Schaltung 12 umfasst außerdem Durchkontaktierungen 17, die die Bauelemente 14 bzw. die Leiterbahnen 16a - c verbinden. Die Leiterbahn 16a befindet sich in der Leiterbahnebene 10a, also an der Oberseite 6. Die Leiterbahn 16b befindet sich auf der Leiterbahnebene 10b, also der Unterseite 8 und die Leiterbahn 16c befindet sich auf der Leiterbahnebene 10c, also in der Mitte bzw. dem Inneren der Trägerplatte 4. Der Übersichtlichkeit halber ist in Fig. 1 nur ein Teil der Schaltung 12 dargestellt.

Die Schaltung 12 nimmt einen volumenhaften Teilbereich 18 der Leiterplatte 2 ein, in Fig. 1 angedeutet durch eine strichpunktierte Linie, insb. auf der Oberseite 6. Der Teilbereich 18 erstreckt sich von der Teilfläche der Oberseite 6 auch senkrecht ins Volumen der Trägerplatte 4.

Die Leiterplatte 2 enthält außerdem eine erfindungsgemäße Schirmung 20, von der in Fig. 1 der Übersichtlichkeit halber nur ein Ausschnitt gezeigt ist. Die Schirmung 20 umfasst eine auf der ersten Leiterbahnebene 10a angeordnete erste Schirmungsleiterbahn 22a, welche den gesamten Teilbereich 18 auf der Leiterbahnebene 10a umgibt. Weiterhin umfasst die Schirmung 20 eine zweite Schirmungsleiterbahn 22b, welche auf der Unterseite 8 ebenfalls den Teilbereich 18 geschlossen umgrenzt. In einem - in diesem Fall mit den Schirmungsleiterbahnen 22a und 22b deckungsgleichen - Umfangsbereich 24, welcher ebenfalls den Teilbereich 18 geschlossen umgrenzt, sind die Schirmungsleiterbahnen 22a,b deckungsgleich, d.h. sind lediglich in Richtung der Senkrechten zu den Flachseiten, also der o.g. Normalenrichtung zueinander verschoben. Die Schirmung 20 umfasst außerdem eine Mehrzahl von Durchkontaktierungen 26, welche jeweils die Schirmungsleiterbahnen 22a,b miteinander elektrisch verbinden und hierzu die Trägerplatte 4 durchdringen. In ihrer Gesamtheit umschließen auch die Durchkontaktierungen 26 den Teilbereich 18.

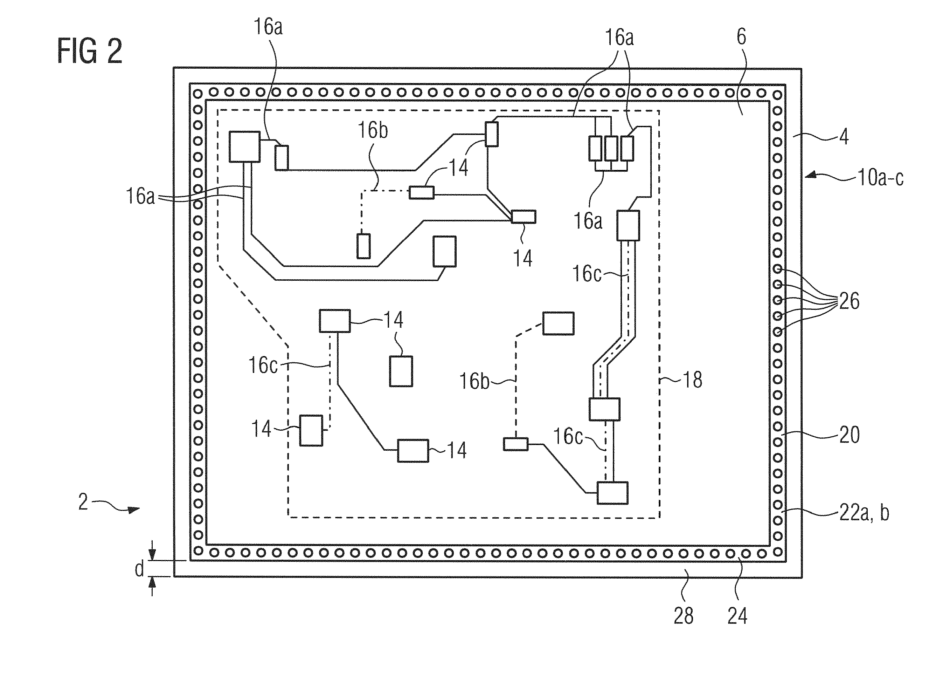

Fig. 2 zeigt die Leiterplatte 2 aus Fig. 1 in Richtung des Pfeils II, also in Draufsicht auf die Oberseite 6. Zur Verdeutlichung der verschiedenen Leiterbahnebenen 10a-c sind hier die jeweils in diesen Ebenen liegenden Leiterbahnen 16a ausgezogen, die Leiterbahnen 16b gestrichelt und die Leiterbahnen 16c strichpunktiert dargestellt. Deutlicher zu erkennen ist in Fig. 2 nochmals der Teilbereich 18 und die gesamte Schirmung 20, welche in den Figs. 1,2 außerdem im Randbereich 28 der Leiterplatte 2 angeordnet ist. Die Schirmung 20 weist also einen geringen, in etwa konstanten Abstand d zum Rand der Leiterplatte 2 von beispielsweise d=1mm auf. Die Schirmungsleiterbahnen 22a,b sind deckungsgleich und begrenzen wieder gleichzeitig den Umfangsbereich 24.

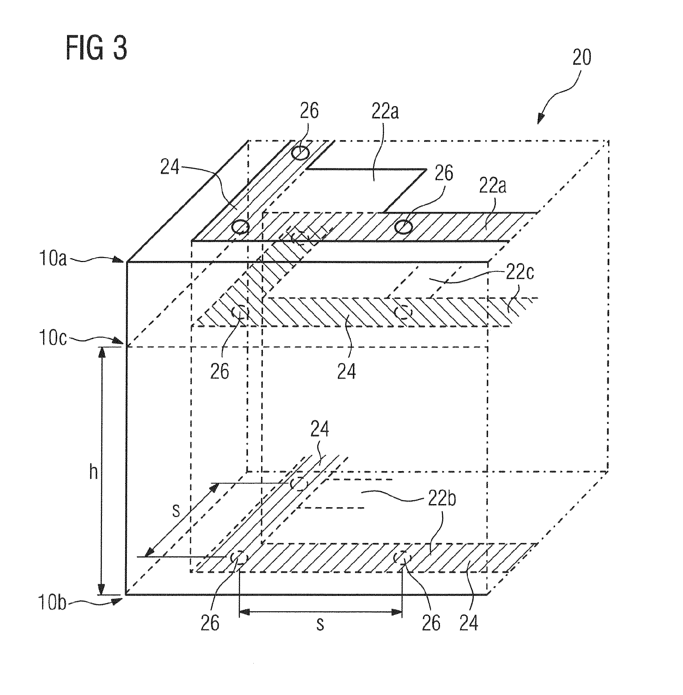

Fig. 3 zeigt eine alternative Ausführungsform einer Schirmung 20, wobei hier die die Durchkontaktierungen 26 der Übersichtlichkeit halber nur durch Kreise angedeutet sind, die deren Schnittflächen mit den Schirmungsleiterbahnen 22a-c darstellen. Fig. 3 zeigt außerdem, dass die Schirmung 20 eine weitere Schirmungsleiterbahn 22c umfasst, welche sich auf einer Zwischenebene, nämlich der Leiterbahnebene 10c, also im Inneren der Trägerplatte 4 befindet. Die Schirmungsleiterbahnen 22a-c sind hier nicht deckungsgleich ausgeführt. Die Schirmungsleiterbahn 22a besitzt z.B. in der dargestellten Ecke eine nach innen reichende quadratische Ausformung. Die Schirmungsleiterbahnen 22b,c je eine zum Inneren der Leiterplatte 2 führende Abzweigung. Lediglich in einem schraffierten Umfangsbereich 24 sind die drei Schirmungsleiterbahnen 22a-c deckungsgleich. Die Durchkontaktierungen 26 befinden sich jedoch alleine im Umfangsbereich 24, da sie dort stets alle drei Schirmungsleiterbahnen 22a-c erreichen und kontaktieren.

Die Abstände s zweier Durchkontaktierungen 26 in Längsrichtung des Umfangsbereiches 24 entsprechen hier dem Abstand h der Leiterbahnebenen 10b und 10c bzw. 10a und 10b, also der gesamten Dicke der Leiterplatte 2.

In den Figs.1-3 umlaufen die Schirmungen 12 den Randbereich 28 der Leiterplatte 2 vollständig, d.h. sie umringen die gesamte Leiterplatte 2.

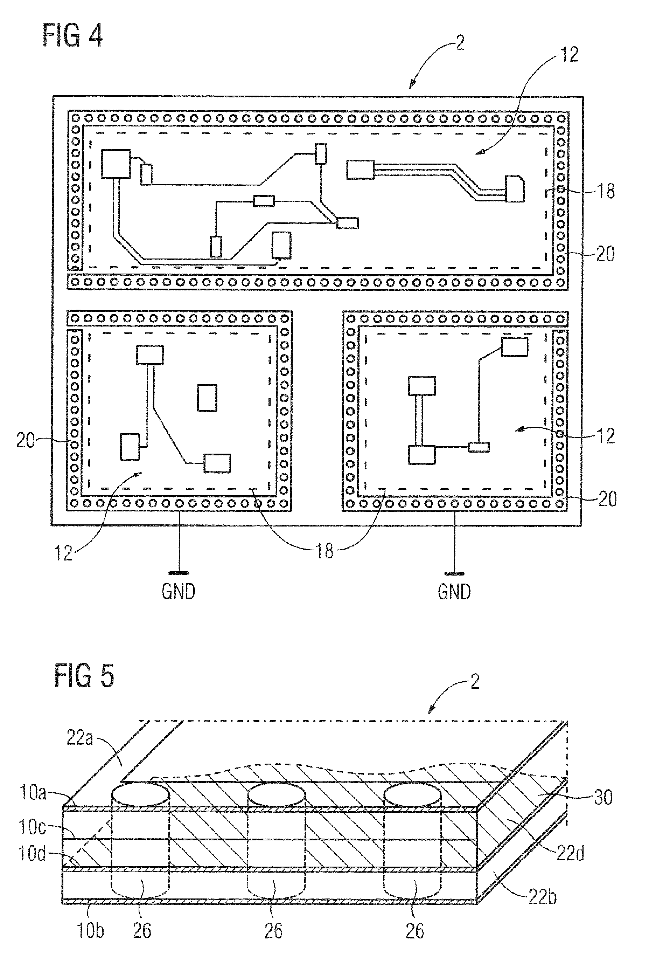

Fig. 4 zeigt eine alternative Leiterplatte 2, welche drei verschiedene Schaltungen 12 beinhaltet. Die drei Schaltungen 12 sollen untereinander gegen Störstrahlung abgeschirmt werden, um jeweilige unerwünschte EMV-Ereignisse in den Schaltungen 12 zu vermeiden. Jede Schaltung 12 nimmt einen eigenen Teilbereich 18 der Leiterplatte 2 ein. Jeder Teilbereich 18 ist deshalb von einer eigenen Schirmung 20, welche jeweils den Schirmungen aus Fig. 1-3 entspricht, umgeben. Die einzelnen Schirmungen 20 umlaufen hier also den jeweiligen Teilbereich 18, nicht jedoch die gesamte Leiterplatte 2.

In Fig. 4 ist außerdem die obere gezeigte große Schirmung 20 als bezüglich ihres Potenzials frei schwebende, floatende Schirmung 20 vollständig isoliert. Sie stehe mit keinem anderen Potential in leitender Verbindung. Die beiden kleineren Schirmungen 20 im unteren Bereich von Fig. 4 sind jedoch jeweils mit einem Massepotenzial GND leitend verbunden, so dass diese beiden Schirmungen 20 ebenfalls auf Massepotenzial GND liegen.

Fig. 5 zeigt einen perspektivischen Schnitt durch eine alternative Leiterplatte 2, welche eine vierte Leiterbahnebene 10d enthält. Hier ist die gesamte Leiterbahnebene 10d in Form einer durchgehenden Masselage 30 ausgeführt, welche die gesamte Leiterplatte 2 überdeckt. Ausnahmen stellen hier lediglich kleinere, nicht dargestellte Öffnungen in der Masselage 30 dar, durch welche nicht dargestellte signalführende Leitungen isoliert durchgeführt werden. Auch die Masselage 30 ist an die Durchkontaktierungen 26 angeschlossen und gehört damit zur Schirmung 20. Die Masselage 30 stellt somit ebenfalls eine Schirmungsleiterbahn 22d dar, welche eine besonders gute EMV-Schirmung der Leiterplatte 2 bewirkt.

In einer alternativen Ausführungsform bildet in Fig.5 auch die Schirmungsleiterbahn 22a eine weiteren Masselage 30. Die Leiterbahnen der Leiterbahnebene 10c, die signalführend sind, sind dann komplett durch die Schirmung 20 in Form zweier Masselagen 30 in den Leiterbahnebenen 10a,d und die Durchkontaktierungen 26 nach allen Raumseiten umgeben bzw. dreidimensional umschlossen.

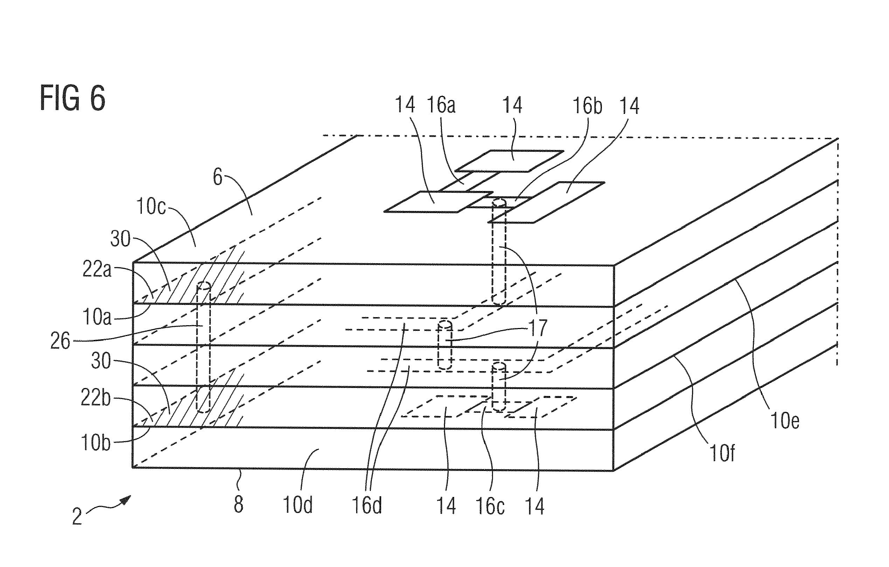

Fig. 6 zeigt eine weitere Leiterplatte 2 mit insgesamt sechs Lagen, also Leiterbahnebenen 10a-f. Die Leiterbahnebenen 10a,b als oberste und unterste innere Lage enthalten zwei Schirmungsleiterbahnen 22a,b, die hier als Masselagen 30 ausgebildet sind, d.h. zu Masselagen 30 entartet sind (angedeutet durch Schraffur). Die Leiterbahnebenen 10c,d befinden sich an der Oberseite 6 und der Unterseite 8 und tragen Bauelemente 14 und lediglich kurze, in Bezug auf Störstrahlung unkritische Leiterbahnen 16a-c der Schaltung 12. Die Leiterbahnebenen 10e,f dagegen tragen die eigentlichen Leiterbahnen 16d der Schaltung 12. Durch die Schirmungsleiterbahnen 22a,b, d.h. die Masselagen 30 und die verbindenden Durchkontaktierungen 26 wird wieder die Schirmung 20 gebildet, die hier die beiden Schaltungslagen, d.h. die Leiterbahnebenen 10e,f vollständig einschließt und gegen Störstrahlung schirmt.

### Bezugszeichenliste

- 2: Leiterplatte
- 4: Trägerplatte
- 6: Oberseite
- 8: Unterseite
- 10a-f: Leiterbahnebene
- 12: Schaltung
- 14: Bauelemente
- 16a-d: Leiterbahn
- 17: Durchkontaktierung
- 18: Teilbereich
- 20: Schirmung
- 22a-d: Schirmungsleiterbahn
- 24: Umfangsbereich
- 26: Durchkontaktierung
- 28: Randbereich
- 30: Masselage

- d,s,h: Abstand
- GND: Massepotential

## Patentansprüche

1. Leiterplatte (2), mit einer eine Oberseite (6) und eine Unterseite (8) aufweisenden, sich flächig erstreckenden Trägerplatte (4), mit mindestens einer ersten Leiterbahnebene (10a) und einer zweiten, zur ersten beabstandeten Leiterbahnebene (10b), mit einer zumindest einen Teilbereich (18) der Trägerplatte (4) einnehmenden elektrischen Schaltung (12), und mit einer die Schaltung (12) gegen elektromagnetische Störstrahlung abschirmenden Schirmung (20),
- wobei die Schirmung (20) eine auf der ersten Leiterbahnebene (10a) angeordnete, den Teilbereich (18) geschlossen umgrenzende, erste Schirmungsleiterbahn (22a),
- und eine auf der zweiten Leiterbahnebene (10b) angeordnete, den Teilbereich (18) geschlossen umgrenzende, zweite Schirmungsleiterbahn (22b) enthält,
- wobei erste (22a) und zweite Schirmungsleiterbahn (22b) zumindest in einem die Schaltung (12) geschlossen umgrenzenden Umfangsbereich (24) deckungsgleich sind,
- und die Schirmung (20) im Umfangsbereich (24) mehrere, die Trägerplatte (4) durchsetzende, die erste (22a) und die zweite Schirmungsleiterbahn (22b) verbindende Durchkontaktierungen (26) enthält.

2. Leiterplatte (2) nach Anspruch 1, bei der die erste Leiterbahnebene (10a) an der Oberseite (6) und die zweite Leiterbahnebene (10b) an der Unterseite (8) angeordnet ist.

3. Leiterplatte (2) nach einem der vorhergehenden Ansprüche, mit mindestens einer, zwischen erster (10a) und zweiter Leiterbahnebene (10b) angeordneten, weiteren Leiterbahnebene (10c), die eine, erster (22a) und zweiter Schirmungsleiterbahn (22b) entsprechende, weitere Schirmungsleiterbahn (22c) enthält, die ebenfalls mit den Durchkontaktierungen (26) verbunden ist.

4. Leiterplatte (2) nach einem der vorhergehenden Ansprüche, bei der mindestens eine der Schirmungsleiterbahnen (22a-c) Teil einer zumindest den Teilbereich (18) ganzflächig ausfüllenden Masselage (30) ist.

5. Leiterplatte (2) nach einem der vorhergehenden Ansprüche, mit einer in deren Randbereich (28) angeordneten, die Leiterplatte (2) vollständig umlaufenden Schirmung (20).

6. Leiterplatte (2) nach einem der vorhergehenden Ansprüche, bei der die Schirmung (20) mit einem Massepotential (GND) verbunden ist.

7. Leiterplatte (2) nach einem der vorhergehenden Ansprüche, mit mehreren, jeweils einen Teilbereich (18) der Trägerplatte (4) einnehmenden elektrischen Schaltungen (12), bei der jede Schaltung (12) eine jeweils diese geschlossen umgrenzende Schirmung (20) aufweist.

8. Leiterplatte (2) nach einem der vorhergehenden Ansprüche, bei der der Abstand (s) zweier benachbarter Durchkontaktierungen (26) zumindest annähernd dem Abstand (h) zweier benachbarter Leiterbahnebenen (10a-f) entspricht.
